# EUROPEAN PATENT SPECIFICATION

(11) **EP 4 287 347 B1**
(45) Date of publication and mention of the grant of the patent: **25.02.2026**
(21) Application number: 22784789.4
(22) Date of filing: 11.03.2022
(51) Int. Cl.: H01M 10/42, H01M 50/54, H01M 50/569, G01J 5/00, H01M 10/48, H01M 10/615, H01M 10/647, H01M 10/6553, H01M 10/657, H01M 50/105, H01M 50/548, H01M 50/557, G01J 5/02, G01R 31/385, G01R 31/54

(54) **APPARATUS AND METHOD FOR INSPECTING ELECTRODE CELL**
VORRICHTUNG UND VERFAHREN ZUR INSPEKTION EINER ELEKTRODENZELLE
APPAREIL ET PROCÉDÉ POUR INSPECTER UNE CELLULE À ÉLECTRODES

(30) Priority: 07.04.2021 KR 20210045522; 28.02.2022 KR 20220026114
(43) Date of publication of application: 06.12.2023
(73) Proprietor: LG Energy Solution, Ltd., Seoul 07335 (KR)
(72) Inventor: CHO, In Hwan, Daejeon 34122 (KR); KIM, Ju Young, Daejeon 34122 (KR); PARK, Sang Dae, Daejeon 34122 (KR); LEE, Ju Mi, Daejeon 34122 (KR)
(74) Representative: Goddar, Heinz J.
(86) International application number: PCT/KR2022/003471
(87) International publication number: WO 2022/215879

(56) References cited:
- EP-A1- 4 006 533
- WO-A1-2018/074161
- JP-A- 2008 145 252
- KR-A- 20140 034 390
- KR-A- 20210 020 576
- KR-B1- 102 146 945
- KR-B1- 102 151 175
- KR-B1- 102 236 815

## Description

### TECHNICAL FIELD

### TECHNICAL FIELD

The present invention relates to an apparatus and method for inspecting an electrode cell, and more particularly, to an apparatus and method for inspecting whether partial disconnection occurs in a tab of an electrode tab.

### BACKGROUND ART

In recent years, the price of energy sources increases due to the depletion of fossil fuels, the interest in environmental pollution is amplified, and the demand for eco-friendly alternative energy sources is becoming an indispensable factor for future life. Accordingly, studies on various power generation technologies such as solar power, wind power, and tidal power are continuing, and power storage devices such as batteries for more efficiently using the generated electrical energy are also of great interest.

Furthermore, as technology development and demand for electronic mobile devices and electric vehicles using batteries increase, the demands for batteries as energy sources are rapidly increasing. Thus, many studies on batteries which are capable of meeting various demands have been conducted.

In particular, in terms of materials, there is a high demand for lithium secondary batteries such as lithium ion batteries and lithium ion polymer batteries having advantages such as high energy density, discharge voltage, and output stability.

The secondary battery may be classified according to the structure of an electrode cell having a positive electrode/separator/negative electrode structure. The stack type secondary battery has a structure in which electrodes, each of which is cut to a certain size, are sequentially stacked with a separator therebetween, and the winding type secondary battery has a structure in which electrodes, each of which is not cut, and a separator interposed between the electrodes are stacked to be wound at the same time.

Particularly, in an electrode cell of a stack type secondary battery, a lead is bonded to a plurality of tabs connected to a plurality of electrodes. Thus, the plurality of electrodes may be electrically connected to an external terminal through the lead.

In the process of manufacturing the electrode cell, there is a possibility that partial disconnection occurs in the tab. For example, the partial disconnection may occur in the tab during the process of forming the tab by processing a non-coating portion of a collector, or the partial disconnection may occur in the tab during the process of bonding the lead to the plurality of tabs. In addition, when the disconnection occurs in the tab, defects such as a low voltage occur in the electrode cell.

However, according to the related art, there has not been an apparatus or method for rapidly detecting the disconnection of the tab of the electrode cell. In addition, although the partial disconnection of the tab is detected through CT scanning, since it takes too long to completely detect the plurality of tabs provided in each of the electrode cells in this manner, there is a problem in that productivity of the electrode cell is deteriorated.

WO 2018/074 161 A1 provides a welding quality inspection method and a welding quality inspection device for a welded part that should make highly accurate welding quality determination possible. The welding quality inspection device is provided with a heat application part for applying heat to a welded part, a temperature detection unit for detecting the temperature of the welded part, and a welding determination unit for determining welding quality on the basis of the temperature variation of the welded part resulting from the heat application.

JP 2008 145 252 A provides an ultrasonic welding inspection apparatus capable of inspecting an ultrasonically-welded state, without having to applying a force to an electrode tab. The ultrasonic-welding inspection apparatus comprises a temperature measuring means for measuring temperature distributions of ultrasonically welded workpieces and a computation means for computing ultrasonically welded regions of the workpieces, through the use of temperature differences between an unjointed region and an ultrasonically jointed region of the workpieces, of which the temperature distributions have been measured.

### DISCLOSURE OF THE INVENTION

### TECHNICAL PROBLEM

An object of the present invention is to provide an apparatus and method for inspecting an electrode cell, which is capable of quickly and accurately inspecting whether partial disconnection with respect to a plurality of tabs occurs.

### TECHNICAL SOLUTION

An apparatus for inspecting an electrode cell according to the present invention is configured to inspect an electrode cell including a plurality of electrodes stacked with a separator therebetween, a plurality of tabs connected to the plurality of electrodes, and a lead bonded to the plurality of tabs. The apparatus for inspecting the electrode cell includes a heater configured to heat the lead; and a thermal detection sensor configured to detect temperature distribution of the plurality of tabs heated by the heat conducted from the lead); or to detect a temperature at a target point of each of the plurality of tabs heated by heat conducted from the lead,

wherein the thermal detection sensor comprises a first thermal detection sensor and a second thermal detection sensor, which are disposed to face each other with a non-bonding part of each of the plurality of tabs therebetween.

The apparatus may further include a controller configured to communicate with the thermal detection sensor. The controller may determine that the electrode cell is defective when a temperature difference between two different points of at least one of the plurality of tabs is out of a preset range, or a difference between a temperature difference between two different points of one tab of the plurality of tabs and a temperature difference between two different points of the other tab is out of the preset range.

The apparatus may further include at least one of: an output interface configured to output a failure occurrence signal when the controller determines that the electrode cell is defective; or an unloader configured to collect the electrode cell from a manufacturing line when the controller determines that the electrode cell is defective.

The heater may include a pair of contact bodies which are in contact with the lead and of which at least one is heated to a preset temperature.

The apparatus may further include a controller configured to communicate with the thermal detection sensor. The controller may determine that the electrode cell is defective when a temperature of at least one of target points of the plurality of tabs is out of a preset range, or a difference between a temperature at a target point of one tab of the plurality of tabs and a temperature at a target point of the other tab is out of the preset range.

A method for inspecting an electrode cell using the apparatus according to the present invention inspects an electrode cell including a plurality of electrodes stacked with a separator therebetween, a plurality of tabs connected to the plurality of electrodes, and a lead bonded to the plurality of tabs. The method for inspecting the electrode cell includes: a heating process of heating the lead; a sensing process of detecting temperature distribution of the plurality of tabs heated by heat conducted from the lead; and a determining process of determining whether the electrode cell is defective based on the temperature distribution of each of the plurality of tabs, wherein, in the determining process, the electrode cell is determined as being defective when a temperature difference between two different points of at least one of the plurality of tabs is out of a preset range, or a difference between a temperature difference between two different points of one tab of the plurality of tabs and a temperature difference between two different points of the other tab is out of the preset range, or based on the temperature at the target point of each of the plurality of tabs, wherein, in the determining process, the electrode cell is determined as being defective when a temperature at a target point of at least one of the plurality of tabs is out of a preset range, or a difference between a temperature at a target point of one tab of the plurality of tabs and a temperature at a target point of the other tab is out of the preset range.

### ADVANTAGEOUS EFFECTS

According to the preferred embodiment of the present invention, whether the partial disconnection with respect to the plurality of tabs occurs may be quickly and accurately inspected by the thermal detection sensor disposed on each of both the sides of the plurality of tabs in the width direction.

In addition, when the disconnection occurs in even one of the plurality of tabs, the corresponding electrode cell may be determined as being defective to easily control the quality of the electrode cell.

### BRIEF DESCRIPTION OF THE DRAWINGS

FIG. 1 is a schematic view illustrating an apparatus for inspecting an electrode cell according to an embodiment of the present invention.
FIG. 2 is a side view illustrating the periphery of an electrode tab and an electrode lead, which are illustrated in FIG. 1.
FIG. 3 is a view for explaining an operation of the apparatus for inspecting the electrode cell according to an embodiment of the present invention.
FIG. 4 is a control block diagram illustrating the apparatus for inspecting the electrode cell according to an embodiment of the present invention.
FIG. 5 is a flowchart illustrating a method for inspecting an electrode cell according to an embodiment of the present invention.
FIG. 6 is a flowchart illustrating a method for inspecting an electrode cell according to another embodiment of the present invention.

### MODE FOR CARRYING OUT THE INVENTION

Hereinafter, preferred embodiments of the present invention will be described in detail with reference to the accompanying drawings so that those of ordinary skill in the art can easily carry out the present invention. However, the present invention may be implemented in several different forms and is not limited or restricted by the following examples.

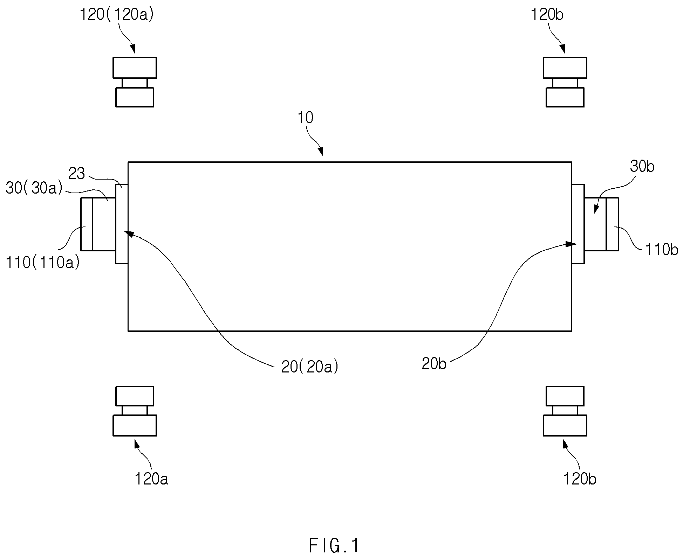

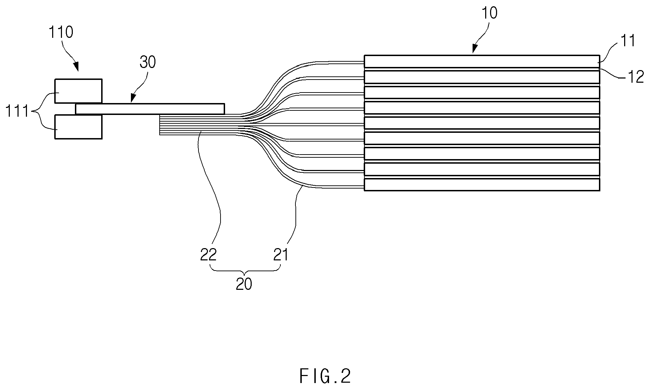

FIG. 1 is a schematic view illustrating an apparatus for inspecting an electrode cell according to an embodiment of the present invention, and FIG. 2 is a side view illustrating the periphery of an electrode tab and an electrode lead, which are illustrated in FIG. 1.

An apparatus for inspecting an electrode cell (hereinafter, referred to as an 'inspection apparatus') according to an embodiment of the present invention may inspect whether partial disconnection occurs in a tab 20 of the electrode cell 10.

The electrode cell 10 may include a plurality of electrodes 11 stacked with a separator 12 therebetween, a plurality of tabs 20 connected to the plurality of electrodes 11, and a lead 30 bonded to the plurality of tabs 20.

The plurality of electrodes 11 may include a positive electrode and a negative electrode, which are stacked with the separator 12 therebetween.

In the plurality of tabs 20, the tab 20 connected to the positive electrode may be a positive electrode tab 20a, and the tab 20 connected to the negative electrode may be a negative electrode tab 20b. The positive electrode tab 20a and the negative electrode tab 20b may protrude in opposite directions with respect to the electrode cell 10. In addition, the lead 30 bonded to the plurality of positive electrode tabs 20a may be a positive electrode lead 30a, and the lead 30 bonded to the plurality of negative electrode tabs 20b may be a negative electrode lead 30b.

Each of the tabs 20 may include a non-bonding part 21 connected to the electrode 11 and spaced apart from an adjacent non-bonding part 21, and a bonding part 22 extending from the non-bonding part 21 and bonded to an adjacent bonding part 22.

At least a portion of the non-bonding part 21 of each of the plurality of tabs 20 may be closer to each other toward the bonding part 22. An extension part 22 may include an outer end of the tab 20.

The lead 30 may be bonded to the bonding part 22. In more detail, a portion including an inner end of the lead 30 may be bonded to the bonding part 22, and the other portion including an outer end of the lead 30 may protrude than from the plurality of tabs 20.

The inspection apparatus according to an embodiment of the present invention may quickly and accurately inspect whether partial disconnection occurs in the plurality of tabs 20 of the electrode cell 10.

In more detail, the inspection device includes a heater 110 for heating the lead 30 and a thermal detection sensor 120 for detecting a temperature distribution of the plurality of tabs 20 heated by heat conducted from the lead 30.

The heater 110 may heat each of the leads 30. In this case, the heater 110 heating the positive electrode lead 30a may be a first heater 110a, and the heater 110 heating the negative electrode lead 30b may be a second heater 110b.

In more detail, the heater 110 may include a pair of contact bodies 111 that are in contact with the lead 30. The pair of contact bodies 111 may be in contact with both surfaces of the lead 30.

For example, the pair of contact bodies 111 may be provided on a gripper that grips the lead 30. As another example, the contact body 111 disposed below the lead 30 may support a bottom surface of the lead 30, and the contact body 111 disposed above the lead 30 may descend toward the lead 30 to be in contact with a top surface of the lead 30.

At least one of the pair of contact bodies 111 may be heated to a preset temperature by induction heating or the like. Thus, the lead 30 may be quickly heated by allowing the contact body 111 heated to a high temperature to be in contact with the lead 30. In addition, since the lead 30 is fixed between the pair of contact bodies 111, the lead 30 may be stably heated.

The pair of contact bodies 111 may be disposed to face each other with the outer end of the lead 30 therebetween. In more detail, the pair of contact bodies 111 may be spaced apart from the plurality of tabs 20 in a longitudinal direction of the lead. As a result, it is possible to prevent a risk, in which the plurality of tabs 20 are directly heated by the heater 110 and thus are thermally damaged, from occurring.

The thermal detection sensor 120 may be disposed at both sides of the plurality of tabs 20 in the width direction. The thermal detection sensor 120 may detect temperature distribution of edges 23 of the plurality of tabs 20 in the longitudinal direction.

The thermal detection sensor 120 includes a first thermal detection sensor and a second thermal detection sensor, which are disposed to face each other with the plurality of tabs 20, more specifically, the non-bonding parts 21 of the plurality of tabs therebetween. Thus, the thermal detection sensor 120 may detect the temperature distribution of both the edges 23 of the plurality of tabs 20 in the longitudinal direction. In more detail, the thermal detection sensor 120 may detect the temperature distribution of both the sides of the edge 23, which are disposed in the width direction, of the non-bonding parts 21 of the plurality of tabs 20 in the longitudinal direction.

The thermal detection sensor 120 disposed at both sides of the plurality of positive electrode tabs 20a may be a positive electrode-side thermal detection sensor 120a, and the thermal detection sensor 120 disposed at both sides of the plurality of negative electrode tabs 20b may be a negative electrode-side thermal detection sensor 120b.

Preferably, each of the thermal detection sensors 120 may be an infrared camera. Therefore, even when the electrode cell 10 is stored in a pouch (not shown), it is possible to detect the temperature distribution of the edges 23 of the plurality of tabs 20 in the longitudinal direction.

However, the configuration of each of the heat sensors 120 is not limited thereto, and it is also possible to detect the temperature distribution in another manner.

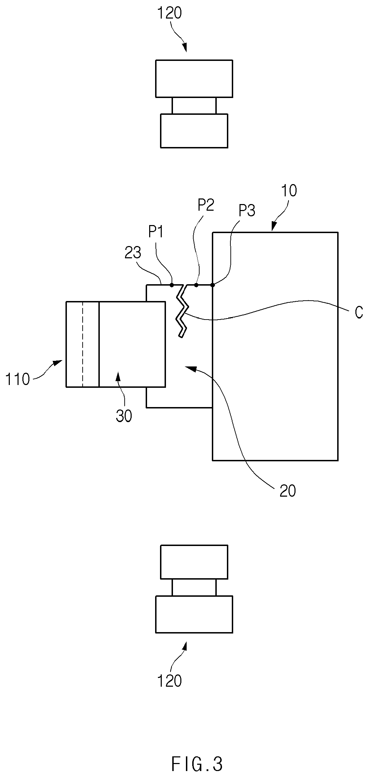

FIG. 3 is a view for explaining an operation of the apparatus for inspecting the electrode cell according to an embodiment of the present invention.

Heat of the heater 110 is thermally conducted to the plurality of tabs 20 through the lead 30. Due to this heat conduction, in both the edges 23 of each of the tabs 20, the temperature distribution occurs, in which a temperature gradually increases toward a portion closer to the lead 30 and gradually decreases toward a portion away from the lead 30. In addition, when a sufficient time elapses after the heater 110 heats the lead 30, the temperature distribution at both the edges 23 of each of the tabs 20 may be uniform.

That is, if the disconnection C does not occur in the edge 23 of the tab 20, linear or constant temperature distribution will be detected by the thermal detection sensor 120 facing the edge 23.

On the other hand, when the disconnection C occurs in the edge 23 of the tab 20, in the temperature distribution detected by the thermal detection sensor 120 facing the edge 23, a significant temperature difference occurs with respect to the disconnection C as a boundary. In more detail, the temperature difference between a first point P disposed at a side of the lead 30 and a second point P2 disposed at an opposite side of the lead 30 with respect to the disconnection C is very large when compared to a case in which the disconnection C does not occur. For example, the temperature difference between the first point P1 and the second point P2 may be 10 degrees Celsius or more.

Thus, it is possible to determine whether the disconnection C of the tab 20 occurs based on the temperature distribution measured by the thermal detection sensor 120.

For example, it may be determined whether the disconnection C of the tab 20 occurs based on the temperature difference in each of the tabs 20. In more detail, it may be determined whether the disconnection C of the tab 20 occurs based on the temperature difference in the edge 23 of the tabs 20. The temperature difference in the edge 23 may mean a maximum value among the temperature differences between the points that are spaced a predetermined distance from each other or are adjacent to each other along the edge 23.

In more detail, when the temperature difference detected at the one tab 20 is greater than a preset normal temperature difference range, it may be determined that the disconnection C occurs in the one tab 20. The normal temperature difference range may be set differently depending on the temperature of the heater 110.

As another example, it may be determined whether the tab 20 is disconnected by comparing the temperature differences between the plurality of tabs 20. In more detail, it may be determined whether the disconnection C of the tab 20 occurs based on the difference between the temperature differences of the edge 23 of each tab 20.

In more detail, when a relatively large temperature difference detected at the edge 23 of one tab 20 and a relatively small temperature difference detected at the edge 23 of the other tab 20 are compared, if the difference is greater than the preset normal range, it may be determined that the disconnection C occurs in the one tab 20.

If the disconnection C occurs in the edge 23 of the tab 20, when compared to the case in which the disconnection C does not occur, the temperature between the disconnection (C) of the edge 23 and the electrode 11 is lowered.

Thus, the thermal detection sensor 120 detects a temperature of a target point P3 on the edge 23 to determine whether the disconnection C of the tab 20 occurs. Preferably, the target point P3 is as close as possible to the electrode 11 among the edges 23. For example, the target point P3 may be a point at which the tab 20 and the electrode 11 are connected to each other.

In this case, the thermal detection sensor 120 may be configured to detect only the temperature of the target point P3 instead of detecting the temperature distribution of the edge 23 of the tab 20.

For example, it may be determined whether the disconnection C of the tab 20 occurs based on the temperature of the target point P3 of each tab 20. In more detail, when the temperature detected at the target point P3 of the one ta b 20 is less than the preset normal temperature range, it is determined that the disconnection C occurs in the one tab 20. In addition, the normal temperature range may be set differently depending on the temperature of the heater 110.

As another example, it may be determined whether the tab 20 is disconnected by comparing the temperatures of the target points P3 of the plurality of tabs 20. In more detail, when the relatively low temperature detected at the target point P3 of one tab 20 and the relatively high temperature detected at the target point P3 of the other tab 20 are compared, if the difference is greater than the preset normal range, it may be determined that the disconnection C occurs in the one tab 20.

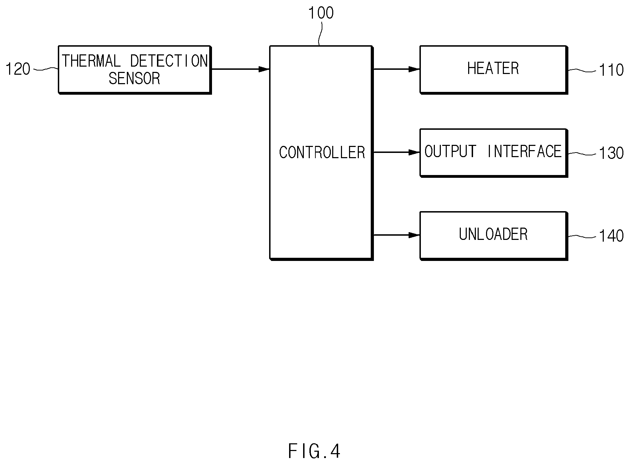

FIG. 4 is a control block diagram illustrating the apparatus for inspecting the electrode cell according to an embodiment of the present invention.

The inspection apparatus according to an embodiment of the present invention may further include a controller 100.

The controller 100 may include at least one processor. The controller 100 may communicate with each of the thermal detection sensors 120 to determine whether the disconnection C occurs in each tab 20. In addition, when the disconnection C occurs in any one of the plurality of tabs 20 provided in the one electrode cell 10, the controller 100 may determine that the one electrode cell 10 is defective.

The inspection device may further include at least one of an output interface 130 or an unloader 140. Hereinafter, a case in which both the output interface 130 and the unloader 140 are provided in the inspection apparatus will be described as an example.

The output interface 130 may be configured to output information related to an operation of the inspection device. For example, the output interface 130 may include a display or speaker.

When the controller 100 determines that the electrode cell 10 is defective, the controller 100 may output a failure occurrence signal through the output interface 130.

The unloader 140 may be configured to selectively collect the electrode cell 10 from a manufacturing line (not shown). For example, the unloader 140 may be a gripper that grips and collects the electrode cell 10.

The controller 100 may control the unloader 140 to collect the electrode cell 10 determined as being defective from the manufacturing line. Thus, the manufactured electrode cells 10 may be easily controlled in quality.

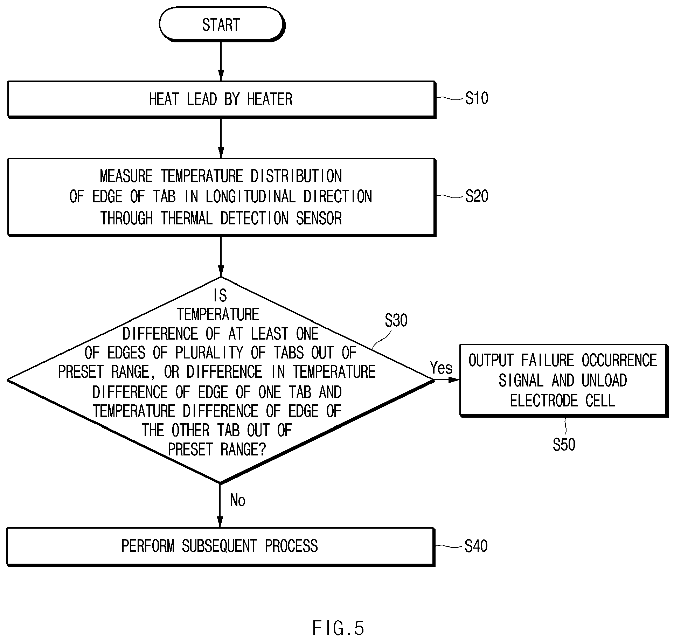

FIG. 5 is a flowchart illustrating a method for inspecting an electrode cell according to an embodiment of the present invention.

A method for inspecting an electrode cell (hereinafter, referred to as an 'inspection method') according to this embodiment may include a heating process (S10), a sensing process (S20), and a determining process (S30).

In the heating process S10, the heater 110 may heat a lead 30 of an electrode cell 10. In more detail, a first heater 110a may heat a positive electrode lead 30a, and a second heater 110b may heat a negative electrode lead 30b.

In more detail, a controller 100 may heat at least one of a pair of contact bodies 111 provided in the heater 110 to a preset temperature and control movement of the pair of contact bodies 111 to be in contact with both surfaces of a lead 30.

In the sensing process S20, a thermal detection sensor 120 may measure temperature distribution of the plurality of tabs 20. In more detail, the thermal detection sensor 120 may measure the temperature distribution of both edges 23 of the plurality of tabs 20 in a longitudinal direction.

In more detail, the thermal detection sensor 120 may measure the temperature distribution of both edges 23 of a non-bonding part 21. In addition, temperature distribution data detected by the thermal detection sensor 120 may be transmitted to the controller 100.

A positive electrode-side thermal detection sensor 120a may measure temperature distribution of both the edges 23 of the plurality of positive electrode tabs 20a in the longitudinal direction, and a negative electrode-side thermal detection sensor 120b may measure temperature distribution of both the edges 23 of the plurality of negative electrode tabs 20b in the longitudinal direction.

In the determining process (S30), the controller 100 may determine whether the electrode cell 10 is defective based on the temperature distribution of the plurality of tabs 20.

If it is determined that disconnection C occurs in at least one of the plurality of positive electrode tabs 20a and the plurality of negative electrode tabs 20b, the controller 100 may determine that the electrode cell 10 is defective.

In more detail, the controller 100 may determine that the electrode cell 10 is defective when the temperature difference between two different points of at least one of the plurality of tabs 20 is out of a preset range, that is, a normal temperature difference range. The controller 100 may determine that the electrode cell 10 is defective when the temperature difference on at least one edge 23 of the plurality of tabs 20 is out of the preset range.

Alternatively, the controller 100 may determine that the electrode cell 10 is defective when a difference between a temperature difference between two different points of one tab 20 of the plurality of tabs 20 and a temperature difference between two different points of the other tab 20 is out of the preset range, i.e., the normal range, the controller 100 may determine that the electrode cell 10 is defective. When the difference between the temperature difference on the edge 23 of one tab 20 and the temperature difference on the edge 23 of the other tab 20 among the plurality of tabs 20 is out of the preset range, the controller 100 may determine that the electrode cell 10 is defective.

If the one electrode cell 10 is not determined as being defective, the one electrode cell 10 may move along a manufacturing line, and then, a subsequent process may be performed (S40).

On the other hand, when the one electrode cell 10 is determined as being defective, a failure occurrence signal is output through an output interface 130, and an unloader 140 may collect the one electrode cell 10 from the manufacturing line (S50).

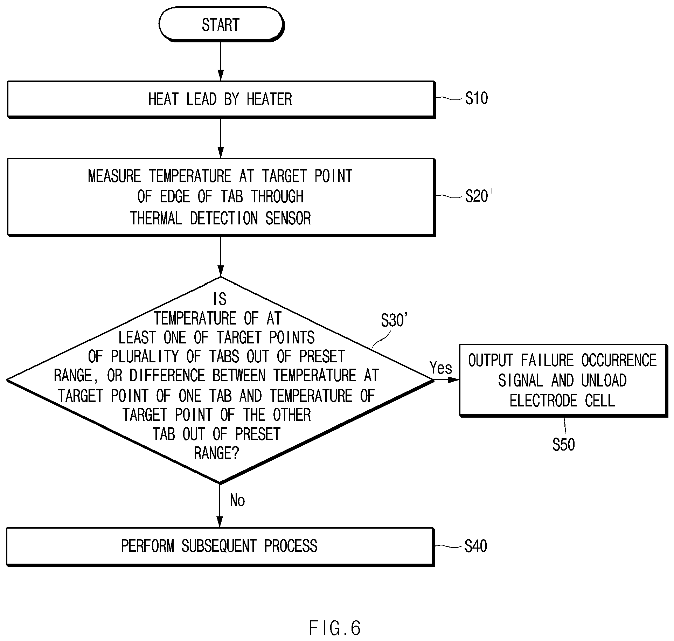

FIG. 6 is a flowchart illustrating a method for inspecting an electrode cell according to another embodiment of the present invention.

An inspection method according to this embodiment is the same as the above-described embodiment except for a sensing process (S20') and a determining process (S30'), and thus, the duplicated contents will be cited, and differences therebetween will be mainly described below.

In the sensing process (S20'), a thermal detection sensor 120 may measure a temperature of a target point P3 of each of a plurality of tabs 20. As described above, the target point P3 may be a point adjacent to an electrode 11 on an edge 23 of each tab 20.

In more detail, a positive electrode-side thermal detection sensor 120a may measure a temperature at the target point P3 on both edges of a plurality of positive electrode tabs 20a, and a negative electrode-side thermal detection sensor 120b may measure a temperature at the target point P3 on both edges 23 of a plurality of negative electrode tabs 20b.

In the determining process (S30'), the controller 100 may determine whether an electrode cell 10 is defective based on the temperature at the target point P3 of each of the plurality of tabs 20.

If it is determined that disconnection C occurs in at least one of the plurality of positive electrode tabs 20a and the plurality of negative electrode tabs 20b, the controller 100 may determine that the electrode cell 10 is defective.

In more detail, a controller 100 may determine that the electrode cell 10 as defective when the temperature of at least one of the target points P3 of the plurality of tabs 20 is out of a preset range, i.e., a normal temperature range.

Alternatively, the controller 100 may determine that the electrode cell 10 is defective when a difference between the temperature at the target point P3 on one tab 20 of the plurality of tabs 20 and a temperature at the target point P3 of the other tab is out of the preset range, i.e., the normal range.

### [Description of the Symbols]

| | | | |
|---|---|---|---|
| 10: | Electrode cell | 11: | Electrode |
| 20: | Tab | 23: | Edge |
| 30: | Lead | 100: | Controller |
| 110: | Heater | 111: | Contact body |
| 120: | Thermal detection sensor | | |

## Claims

1. An apparatus for inspecting an electrode cell (10), configured to inspect an electrode cell (10) comprising a plurality of electrodes (11) stacked with a separator (12) therebetween, a plurality of tabs (20) connected to the plurality of electrodes (11), and a lead (30) bonded to the plurality of tabs (20), the apparatus comprising:
a heater (110) configured to heat the lead (30); and
a thermal detection sensor (120) configured to detect temperature distribution of the plurality of tabs (20) heated by heat conducted from the lead (30); or to detect a temperature at a target point (P3) of each of the plurality of tabs (20) heated by heat conducted from the lead (30),
wherein the thermal detection sensor (120) comprises a first thermal detection sensor and a second thermal detection sensor, which are disposed to face each other with a non-bonding part (21) of each of the plurality of tabs (20) therebetween.

2. The apparatus of claim 1, further comprising a controller (100) configured to communicate with the thermal detection sensor (120),
wherein the controller (100) is configured to determine that the electrode cell (10) is defective when a temperature difference between two different points (P1, P2) of at least one of the plurality of tabs (20) is out of a preset range, or a difference between a temperature difference between two different points (P1, P2) of one tab of the plurality of tabs (20) and a temperature difference between two different points (P1, P2) of the other tab is out of the preset range.

3. The apparatus of claim 2, further comprising at least one of:
an output interface (130) configured to output a failure occurrence signal when the controller (100) determines that the electrode cell is defective; or
an unloader (140) configured to collect the electrode cell (10) from a manufacturing line when the controller (100) determines that the electrode cell is defective.

4. The apparatus of claim 1, wherein the heater (110) comprises a pair of contact bodies (111) which are in contact with the lead (30) and of which at least one is heated to a preset temperature.

5. The apparatus of claim 1, further comprising a controller (100) configured to communicate with the thermal detection sensor (120),
wherein the controller (100) is configured to determine that the electrode cell (10) is defective when a temperature of at least one of target points (P3) of the plurality of tabs (20) is out of a preset range, or a difference between a temperature at a target point (P3) of one tab of the plurality of tabs (20) and a temperature at a target point (P3) of the other tab is out of the preset range.

6. A method for inspecting an electrode cell (10) using the apparatus of claim 1, which inspects an electrode cell (10) comprising a plurality of electrodes (11) stacked with a separator (12) therebetween, a plurality of tabs (20) connected to the plurality of electrodes (11), and a lead (30) bonded to the plurality of tabs, the method comprising:
a heating process (S10) of heating the lead (30);
a sensing process (S20) of detecting temperature distribution of the plurality of tabs (20) heated by heat conducted from the lead (30); and
a determining process (S30) of determining whether the electrode cell (10) is defective based on the temperature distribution of each of the plurality of tabs (20),
wherein, in the determining process (S30), the electrode cell (10) is determined as being defective when a temperature difference between two different points (P1, P2) of at least one of the plurality of tabs (20) is out of a preset range, or a difference between a temperature difference between two different points (P1, P2) of one tab of the plurality of tabs (20) and a temperature difference between two different points (P1, P2) of the other tab is out of the preset range, or
based on the temperature at the target point (P3) of each of the plurality of tabs (20),
wherein, in the determining process (S30), the electrode cell (10) is determined as being defective when a temperature at a target point (P3) of at least one of the plurality of tabs (20) is out of a preset range, or a difference between a temperature at a target point (P3) of one tab of the plurality of tabs (20) and a temperature at a target point (P3) of the other tab is out of the preset range.

## Patentansprüche

1. Vorrichtung zum Prüfen einer Elektrodenzelle (10), die konfiguriert ist, um eine Elektrodenzelle (10) zu prüfen, die eine Vielzahl von Elektroden (11), die mit einem Separator (12) dazwischen gestapelt sind, eine Vielzahl von Laschen (20), die mit der Vielzahl von Elektroden (11) verbunden sind, und eine Leitung (30), die mit der Vielzahl von Laschen (20) verbunden ist, umfasst, wobei die Vorrichtung Folgendes umfasst:
eine Heizvorrichtung (110), die konfiguriert ist, um die Leitung (30) zu erwärmen; und
einen Wärmeerfassungssensor (120), der konfiguriert ist, um eine Temperaturverteilung der Vielzahl von Laschen (20), die durch von der Leitung (30) geleitete Wärme erwärmt werden, zu erfassen; oder um eine Temperatur an einem Zielpunkt (P3) an jeder der Vielzahl von Laschen (20), die durch von der Leitung (30) geleitete Wärme erwärmt werden, zu erfassen,
wobei der Wärmeerfassungssensor (120) einen ersten Wärmeerfassungssensor und einen zweiten Wärmeerfassungssensor umfasst, die so angeordnet sind, dass sie einander mit einem Nicht-Verbindungsteil (21) von jeder der Vielzahl von Laschen (20) dazwischen zugewandt sind.

2. Vorrichtung nach Anspruch 1, die ferner eine Steuerung (100) umfasst, die konfiguriert ist, um mit dem Wärmeerfassungssensor (120) zu kommunizieren,
wobei die Steuerung (100) konfiguriert ist, um zu bestimmen, dass die Elektrodenzelle (10) defekt ist, wenn eine Temperaturdifferenz zwischen zwei verschiedenen Punkten (P1, P2) von mindestens einer der Vielzahl von Laschen (20) außerhalb eines voreingestellten Bereichs liegt oder eine Differenz zwischen einer Temperaturdifferenz zwischen zwei verschiedenen Punkten (P1, P2) einer Lasche der Vielzahl von Laschen (20) und einer Temperaturdifferenz zwischen zwei verschiedenen Punkten (P1, P2) der anderen Lasche außerhalb des voreingestellten Bereichs liegt.

3. Vorrichtung nach Anspruch 2, die ferner mindestens eines von Folgendem umfasst:
eine Ausgabeschnittstelle (130), die konfiguriert ist, um ein Fehlerauftrittssignal auszugeben, wenn die Steuerung (100) bestimmt, dass die Elektrodenzelle defekt ist; oder
einen Entlader (140), der konfiguriert ist, um die Elektrodenzelle (10) von einer Fertigungsstraße zu sammeln, wenn die Steuerung (100) bestimmt, dass die Elektrodenzelle defekt ist.

4. Vorrichtung nach Anspruch 1, bei der die Heizvorrichtung (110) ein Paar Kontaktkörper (111) umfasst, die mit der Leitung (30) in Kontakt stehen und von denen mindestens einer auf eine voreingestellte Temperatur erwärmt wird.

5. Vorrichtung nach Anspruch 1, die ferner eine Steuerung (100) umfasst, die konfiguriert ist, um mit dem Wärmeerfassungssensor (120) zu kommunizieren,
wobei die Steuerung (100) konfiguriert ist, um zu bestimmen, dass die Elektrodenzelle (10) defekt ist, wenn eine Temperatur von mindestens einem der Zielpunkte (P3) der Vielzahl von Laschen (20) außerhalb eines voreingestellten Bereichs liegt oder eine Differenz zwischen einer Temperatur an einem Zielpunkt (P3) einer Lasche der Vielzahl von Laschen (20) und einer Temperatur an einem Zielpunkt (P3) der anderen Lasche außerhalb des voreingestellten Bereichs liegt.

6. Verfahren zum Prüfen einer Elektrodenzelle (10) unter Verwendung der Vorrichtung nach Anspruch 1, die eine Elektrodenzelle (10) prüft, die eine Vielzahl von Elektroden (11), die mit einem Separator (12) dazwischen gestapelt sind, eine Vielzahl von Laschen (20), die mit der Vielzahl von Elektroden (11) verbunden sind, und eine Leitung (30), die mit der Vielzahl von Laschen verbunden ist, umfasst, wobei das Verfahren Folgendes umfasst:
einen Erwärmungsprozess (S10) zum Erwärmen der Leitung (30);
einen Erfassungsprozess (S20) zum Erfassen einer Temperaturverteilung der Vielzahl von Laschen (20), die durch von der Leitung (30) geleitete Wärme erwärmt werden; und
einen Bestimmungsprozess (S30) zum Bestimmen, ob die Elektrodenzelle (10) defekt ist, basierend auf der Temperaturverteilung von jeder der Vielzahl von Laschen (20),
wobei in dem Bestimmungsprozess (S30) bestimmt wird, dass die Elektrodenzelle (10) defekt ist, wenn eine Temperaturdifferenz zwischen zwei verschiedenen Punkten (P1, P2) von mindestens einer der Vielzahl von Laschen (20) außerhalb eines voreingestellten Bereichs liegt oder eine Differenz zwischen einer Temperaturdifferenz zwischen zwei verschiedenen Punkten (P1, P2) einer Lasche der Vielzahl von Laschen (20) und einer Temperaturdifferenz zwischen zwei verschiedenen Punkten (P1, P2) der anderen Lasche außerhalb des voreingestellten Bereichs liegt, oder
basierend auf der Temperatur an dem Zielpunkt (P3) von jeder der Vielzahl von Laschen (20),
wobei in dem Bestimmungsprozess (S30) bestimmt wird, dass die Elektrodenzelle (10) defekt ist, wenn eine Temperatur an einem Zielpunkt (P3) von mindestens einer der Vielzahl von Laschen (20) außerhalb eines voreingestellten Bereichs liegt oder eine Differenz zwischen einer Temperatur an einem Zielpunkt (P3) einer Lasche der Vielzahl von Laschen (20) und einer Temperatur an einem Zielpunkt (P3) der anderen Lasche außerhalb des voreingestellten Bereichs liegt.

## Revendications

1. Appareil pour inspecter une cellule d'électrode (10), configuré pour inspecter une cellule d'électrode (10) comprenant une pluralité d'électrodes (11) empilées avec un séparateur (12) entre elles, une pluralité de languettes (20) reliées à la pluralité d'électrodes (11), et un conducteur (30) fixé sur la pluralité de languettes (20), l'appareil comprenant :
un élément chauffant (110) configuré pour chauffer le conducteur (30) ; et
un capteur de détection thermique (120) configuré pour détecter une distribution de température de la pluralité de languettes (20) chauffées par la chaleur véhiculée par le conducteur (30) ; ou pour détecter une température en un point cible (P3) de chacune de la pluralité de languettes (20) chauffées par la chaleur véhiculée par le conducteur (30),
le capteur de détection thermique (120) comprenant un premier capteur de détection thermique et un deuxième capteur de détection thermique, disposés l'un en face de l'autre avec une partie non liante (21) de chacune de la pluralité de languettes (20) entre eux.

2. Appareil selon la revendication 1, comprenant en outre un contrôleur (100) configuré pour communiquer avec le capteur de détection thermique (120),
le contrôleur (100) étant configuré pour établir que la cellule d'électrode (10) est défaillante lorsqu'une différence de température entre deux points différents (P1, P2) d'au moins une de la pluralité de languettes (20) se trouve hors d'une plage préétablie, ou une différence entre une différence de température entre deux points différents (P1, P2) d'une languette de la pluralité de languettes (20) et une différence de température entre deux points différents (P1, P2) de l'autre languette se trouve hors de la plage préétablie.

3. Appareil selon la revendication 2, comprenant en outre au moins un :
d'une interface de sortie (130) configurée pour émettre un signal d'occurrence de défaillance lorsque le contrôleur (100) établit que la cellule d'électrode est défaillante ; ou
d'un déchargeur (140) configuré pour collecter la cellule d'électrode (10) d'une chaîne de fabrication lorsque le contrôleur (100) établit que la cellule d'électrode est défaillante.

4. Appareil selon la revendication 1, l'élément chauffant (110) comprenant une paire de corps de contact (111) au contact du conducteur (30), et dont au moins un est chauffé à une température préétablie.

5. Appareil selon la revendication 1, comprenant en outre un contrôleur (100) configuré pour communiquer avec le capteur de détection thermique (120),
le contrôleur (100) étant configuré pour établir que la cellule d'électrode (10) est défaillante lorsqu'une température d'au moins un des points cibles (P3) de la pluralité de languettes (20) se trouve hors d'une plage préétablie, ou une différence entre une température en un point cible (P3) d'une languette de la pluralité de languettes (20) et une température en un point cible (P3) de l'autre languette se trouve hors de la plage préétablie.

6. Procédé pour inspecter une cellule d'électrode (10) en utilisant l'appareil selon la revendication 1, inspectant une cellule d'électrode (10) comprenant une pluralité d'électrodes (11) empilées avec un séparateur (12) entre elles, une pluralité de languettes (20) reliées à la pluralité d'électrodes (11), et un conducteur (30) lié à la pluralité de languettes, le procédé comprenant :
un processus de chauffage (S10) comportant le chauffage du conducteur (30) ;
un processus de détection (S20) comportant la détection d'une distribution de température de la pluralité de languettes (20) chauffées par une chaleur véhiculée par le conducteur (30) ; et
un processus de détermination (S30) comportant la détermination si la cellule d'électrode (10) est défaillante d'après la distribution de température de chacune de la pluralité de languettes (20),
la cellule d'électrode (10) étant établie, au cours du processus de détermination (S30), comme étant défaillante lorsqu'une différence de température entre deux points différents (P1, P2) d'au moins une de la pluralité de languettes (20) se trouve hors d'une plage préétablie, ou une différence entre une différence de température entre deux points différents (P1, P2) d'une languette de la pluralité de languettes (20) et une différence de température entre deux points différents (P1, P2) de l'autre languette se trouve hors de la plage préétablie, ou
d'après la température au point cible (P3) de chacune de la pluralité de languettes (20),
la cellule d'électrode (10) étant établie, au cours du processus de détermination (S30), comme étant défaillante lorsqu'une température en un point cible (P3) d'au moins une de la pluralité de languettes (20) se trouve hors d'une plage préétablie, ou une différence entre une température en un point cible (P3) d'une languette de la pluralité de languettes (20) et une température en un point cible (P3) de l'autre languette se trouve hors de la plage préétablie.
